Europäisches Patentamt

European Patent Office

Office européen des brevets

(11) Numéro de publication: **0 425 374 A1**

# (12) DEMANDE DE BREVET EUROPEEN

(21) Numéro de dépôt: 90402998.0

(22) Date de dépôt: 24.10.90

(51) Int. Cl.5: **G01R 31/02**

(30) Priorité: 26.10.89 FR 8914040

(43) Date de publication de la demande:
**02.05.91 Bulletin 91/18**

(84) Etats contractants désignés:
**DE GB SE**

(71) Demandeur: **ETAT FRANCAIS représenté par le Ministre des Postes, Télécommunications et de l'Espace**
**(CENTRE NATIONAL D'ETUDES DES TELECOMMUNICATIONS), 38-40 rue du Général Leclerc**
**F-92131 Issy-les-Moulineaux(FR)**

(72) Inventeur: **Fieau, Jean-Claude**
**41, rue de Toul Ar Lann**
**F-22700 Perros-Guirec(FR)**
Inventeur: **Fort, Joseph**
**17, rue Croas Nevez**
**F-22700 Louannec(FR)**

(74) Mandataire: **Martinet & Lapoux**
**62, rue des Mathurins**
**F-75008 Paris(FR)**

(54) Dispositif de test d'un bus à deux paires de conducteurs.

(57) Le dispositif vérifie le branchement des fils conducteurs d'un bus (BU) tel qu'un bus distribué dans un réseau local. Il comprend deux modules de test (1M, 2M) à connecter aux borniers (1B, 2B) du bus (BU). Le premier module (1M) comporte une source de tension (SA) et décèle des discontinuités électriques dans les paires de fils (P1, P2), et un croisement anormal entre deux fils de l'une et l'autre paire, lorsque le second bornier (28) est relié directement à des impédances terminales (RT1, RT2) du bus. Le second module (2M) signale un croisement de paires de fil (P1, P2) et des croisements des fils dans une paire. Ces divers tests sont effectués par sollicitation d'interrupteurs (I1, I2, I3), et ont leurs résultats interprétés en fonction de l'activation et la désactivation de détecteurs de courant tels que LED (DR, DV).

FIG.7

## DISPOSITIF DE TEST D'UN BUS À DEUX PAIRES DE CONDUCTEURS

La présente invention concerne un dispositif pour tester un bus comprenant au moins deux paires de fils conducteurs distincts, disposés en parallèle entre deux borniers à quatre bornes chacun, selon un ordre prédéterminé.

Lorsque le bus est un bus de transmission où les paires sont assignées à des sens respectifs opposés de transmission de signaux, chaque fil d'une paire a une polarité bien distincte par rapport à celle de l'autre fil de la même paire. Il convient donc de s'assurer, lors de la pose des fils conducteurs, que les extrémités de chacun des fils est bien reliée aux bornes correspondantes repérées sur les deux borniers d'extrémité du bus. Si des croisements de fils et des permutations des paires arrivent fréquemment lors du câblage du bus, une autre anomalie est beaucoup plus fréquente, consistant en une rupture de continuité électrique dans les paires de conducteurs. Cette rupture de continuité électrique provient soit d'un défaut de liaison par résistance notamment à l'une des extrémités du bus entre les deux fils d'une paire, soit d'une micro-rupture d'un fil entre les deux extrémités du bus.

La présente invention vise donc à fournir un dispositif pour tester rapidement un bus à quatre fils conducteurs afin de détecter principalement des défauts de continuité électrique dans le bus, et en addition, des défauts de câblage des fils dans le bus. En outre, l'invention vise également à fournir un dispositif de test de bus incluant des composants électroniques simples et bon marché.

A cette fin, un dispositif pour tester un bus, le bus comprenant
des premier, second, troisième et quatrième fils conducteurs parallèles,
un premier bornier ayant des première, seconde, troisième et quatrième bornes respectivement reliées normalement à des premières extrémités des premier, second, troisième et quatrième fils conducteurs,
un second bornier ayant des première, seconde, troisième et quatrième bornes respectivement reliées normalement à des secondes extrémités des premier, second, troisième et quatrième fils conducteurs, et
des première et seconde impédances terminales connectables respectivement aux première et seconde bornes du second bornier et aux troisième et quatrième bornes du second bornier,
est caractérisé en ce qu'il comprend
une source de tension continue,
un premier interrupteur connectable aux première et seconde bornes du premier bornier,
un second interrupteur relié en série avec la source de tension et le premier interrupteur et connectable aux troisième et quatrième bornes du premier bornier,
un premier moyen détecteur de courant polarisé directement par la source de tension et interconnecté entre la source de tension et lesdits interrupteurs, et
un second moyen détecteur de courant polarisé directement par la source de tension et interconnecté en série entre les premier et second interrupteurs.

Les premier et second moyens détecteurs de courant sont activés lorsqu'il n'existe aucune discontinuité électrique aussi bien dans la première paire des premier et second fils conducteurs que dans la seconde paire des troisième et quatrième fils conducteurs. Si le second moyen détecteur de courant est désactivé lorsque le premier interrupteur est fermé, ceci signifie que la seconde paire présente une discontinuité électrique. Réciproquement, si le second moyen détecteur de courant est désactivé lorsque le second interrupteur de courant est fermé, et que le premier interrupteur est ouvert, ceci signifie qu'il existe une discontinuité électrique dans la première paire de conducteurs.

Selon une autre caractéristique de l'invention, le dispositif de test comprend un troisième moyen détecteur de courant qui est connecté en antiparallèle avec le second moyen détecteur de courant. Le troisième moyen détecteur de courant est utilisé quand le bus comporte un croisement indésirable de l'un des fils de la première paire avec l'un des fils de la seconde paire.

Selon une autre caractéristique de l'invention, le dispositif de test comprend des cinquième et sixième moyens détecteurs de courant connectables en antiparallèle entre les seconde et troisième bornes du second bornier du bus. Les cinquième et sixième moyens détecteurs de courant servent à signaler une permutation totale des extrémités des deux paires de conducteurs au niveau de l'un des borniers du bus.

Selon encore une autre caractéristique de l'invention, le dispositif de test comprend des septième et huitième moyens détecteurs de courant connectables en antiparallèle entre les première et seconde bornes du second bornier du bus, et des neuvième et dixième moyens détecteurs de courant connectables en antiparallèle entre les troisième et quatrième bornes du second bornier. Ces quatre derniers moyens détecteurs de courant sont utilisés pour signaler une permutation indésirable des premier et second fils conducteurs dans la première paire et/ou une permutation indésirable des troisième et quatrième fils conducteurs dans la seconde paire.

D'autres caractéristiques et avantages de la présente invention apparaîtront plus clairement à la lecture de la description de plusieurs réalisations préférées de l'invention en référence aux dessins annexés correspondants dans lesquels :

- la Fig. 1 est un schéma électrique d'un premier module d'un dispositif de test conforme à l'invention, connecté à un premier bornier d'un bus à tester montré dans une configuration normale ;

- la Fig. 2 est un schéma analogue à la Fig. 1, lorsque des premier et second interrupteurs dans le premier module sont respectivement fermé et ouvert et qu'il existe une discontinuité électrique dans une première paire de conducteurs du bus ;

- les Figs. 3 et 4 sont des schémas analogues à la Fig. 1, lorsque les deux interrupteurs sont ouverts et lorsque deux fils voisins et deux fils éloignés dans les deux paires du bus sont croisées, respectivement;

- les Figs. 5 et 6 sont des schémas analogues à la Fig. 1, lorsque les interrupteurs sont ouverts et lorsque des premier et troisième fils du bus et des second et quatrième fils du bus sont involontairement croisés, respectivement ;

- la Fig. 7 est un schéma électrique montrant un dispositif de test complet comprenant un premier module comme connecté selon la Fig. 1, et un second module connecté à un second bornier du bus ;

- la Fig. 8 est un schéma électrique analogue à celui de la Fig. 7 lorsque les paires de fils conducteurs du bus sont involontairement croisées ;

- la Fig 9 est un schéma électrique analogue à celui de la Fig. 7, lorsque l'interrupteur dans le second module est ouvert ;

- la Fig. 10 est un schéma électrique analogue à celui de la Fig. 9, lorsque les deux fils de la première paire du bus sont involontairement croisés ;

- les Figs. 11 et 12 montrent des réalisations pratiques des premier et second modules du dispositif de test, respectivement ;

- la Fig. 13 montre un assemblage des premier et second modules, destiné à permettre le test de bon état de fonctionnement de ces modules ; et

- la Fig. 14 montre schématiquement un bus distribué à tester par le dispositif de test selon l'invention.

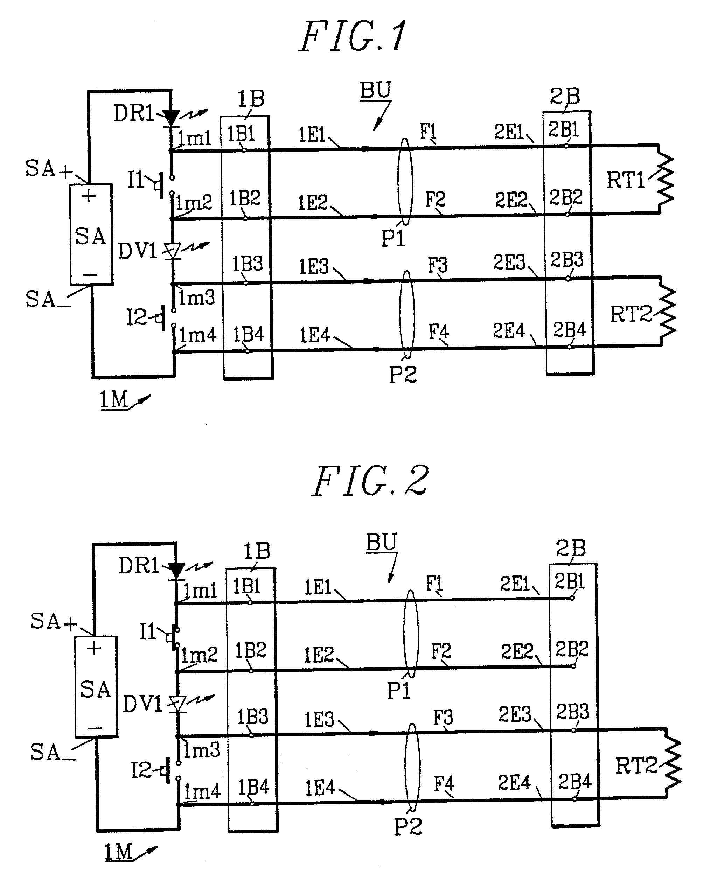

En référence à la Fig. 1, un bus BU à tester est composé de deux paires de fils conducteurs P1 et P2 qui s'étendent parallèlement entre deux borniers 1B et 2B. Les liaisons entre les fils conducteurs du bus et les bornes des borniers sont réalisées suivant un ordre prédéterminé. Au niveau du premier bornier 1B, des premières extrémités 1E1 et 1E2 des fils F1 et F2 de la première paire P1 et des premières extrémités 1E3 et 1E4 des fils F3 et F4 de la seconde paire P2 sont respectivement reliées aux bornes 1B1, 1B2, 1B3 et 1B4 du bornier 1B. A l'autre extrémité du bus, des secondes extrémités 2E1 et 2E2 des fils conducteurs F1 et F2 de la première paire P1 et des secondes extrémités 2E3 et 2E4 des fils conducteurs F3 et F4 de la seconde paire P2 sont respectivement reliées à des bornes 2B1, 2B2, 2B3 et 2B4 du second bornier 2B.

Un tel bus peut s'étendre sur plusieurs centaines de mètres, voire plusieurs kilomètres. Comme déjà dit, lors de la pose du bus et du câblage de celui-ci aux borniers, certaines anomalies soit dans au moins un fil conducteur soit au niveau des liaisons des fils aux borniers peuvent apparaître.

Dans la Fig. 1 le bus est dans l'état normal et est connecté à deux impédances terminales. Ces impédances sont ici sous la forme de résistances RT1 et RT2 respectivement connectées entre les bornes 2B1 et 2B2 et entre les bornes 2B3 et 2B4 du second bornier 2B.

Un dispositif de test de bus de fils conducteurs selon l'invention comprend un premier module de test 1M, également montré à la Fig. 1. Ce premier module comprend une source d'alimentation de tension continue SA ayant des bornes positive SA+ et négative SA-, une première diode électroluminescente (LED) DR1, un premier interrupteur I1, une seconde diode électroluminescente DV1 et un second interrupteur I2 qui sont respectivement connectés en série entre les bornes SA+ et SA-. Les diodes DR1 et DR2 sont polarisées directement dans le sens de la borne SA+ vers la borne SA- à travers les interrupteurs et sont respectivement associées à deux couleurs différentes, par exemple rouge (R) et verte (V). Le module 1M offre quatre bornes 1m1 à 1m4 qui sont respectivement connectables aux bornes 1B1 à 1B4 du premier bornier 1B, à l'opposé du bus BU. Les bornes 1m1 et 1m2 sont celles de l'interrupteur I1, qui sont respectivement connectées à la cathode de la diode DR1 et à l'anode de la diode DV1. Les bornes 1m3 et 1m4 sont celles de l'interrupteur I2 qui sont respectivement connectées à la cathode de la diode DV1 et à la borne de source d'alimentation SA-.

Le module 1M est destiné à déceler deux types d'anomalie dans le bus BU, à savoir des discontinuités électriques dans les paires de conducteurs P1 et P2 et un croisement anormal entre l'un des fils de l'une des deux paires P1 et P2 et l'un des fils de l'autre paire.

Dans la Fig. 2 est montrée une anomalie du premier type, à savoir un défaut de continuité électrique dans la première paire P1 réalisée ici par une absence de la résistance terminale RT1, bien qu'une telle anomalie puisse être une coupure dans au moins l'un des fils F1 et F2, ou une déconnexion de l'une des bornes de la résistance RT1 au bornier 2B. Lors de la connexion par enfichage du module 1M au bornier 1B, si les diodes DR1 et DV1 s'allument, le bus ne présente aucun défaut de continuité électrique. Par contre lors de l'enfichage précédent, si les diodes DR1 et DV1 sont éteintes, ceci indique qu'il existe un défaut de continuité électrique au moins dans l'une des paires de fils conducteurs P1 et P2.

Les interrupteurs I1 et I2 étant à l'état ouvert de repos lors de l'enfichage, comme montré à la Fig. 1, si on ferme le premier interrupteur I1 pour courtcircuiter la paire P1, comme montré à la Fig. 2, deux cas peuvent se présenter. Si les diodes DR1 et DV1 sont à nouveau allumées, ceci signifie que la première paire P1 présente un défaut de continuité électrique, tel qu'absence de la résistance RT1 ou mauvaise connexion de celle-ci au bornier 2B. Si l'extinction des diodes DR1 et DV1 persiste, ceci laisse supposer qu'il existe un défaut de continuité électrique dans la seconde paire P2, et éventuellement un défaut de continuité électrique dans la première paire P1.

Dans ce dernier cas de figure, on continue le test, l'interrupteur I1 est alors relâché en position ouverte et l'interrupteur I2 est fermé pour courtcircuiter la paire P2. Si les diodes DR1 et DV1 sont allumées, il n'existe point de défaut de continuité électrique dans la première paire P1, mais par contre la seconde paire P2 présente un tel défaut. Au contraire si les diodes DR1 et DV1 sont éteintes lorsque le second interrupteur I2 est fermé, ceci indique qu'il existe des défauts de continuité dans les deux paires P1 et P2.

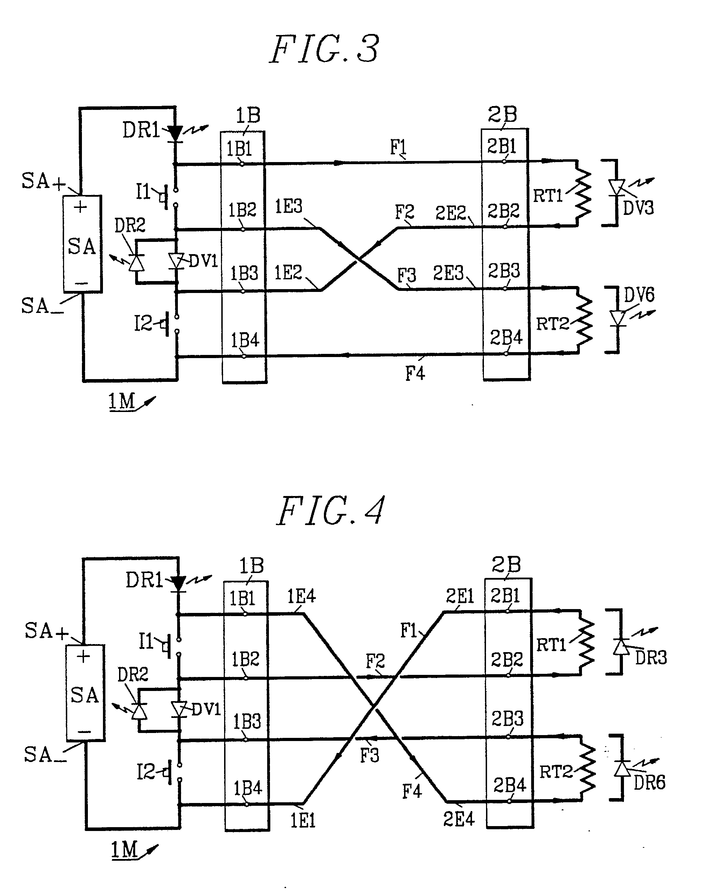

Dans une seconde réalisation du premier module 1M, une seconde diode rouge DR2 est reliée en antiparallèle à la diode DV1 en vue de signaler des croisements entre fils des paires, comme montré aux Figs. 3 à 6.

On notera que la première diode DR1 indique par son activation la continuité électrique dans les deux paires P1 et P2 du bus BU quelle que soit l'inversion des fils entre les paires, comme on le verra ci-dessous. Ainsi, selon une autre variante, la diode DR1 peut être insérée entre la borne 1m4 de l'interrupteur I2 et la borne d'alimentation SA-.

Les Figs. 3 et 4 concernent un croisement des fils "voisins" F2 et F3 des paires P1 et P2 et un croisement des fils "éloignés" F1 et F4 des paires P1 et P2. Comparativement à la configuration normale du bus BU selon la Fig. 1, les premières (ou secondes) extrémités 1E2 et 1E3 des fils F2 et F3 dans la Fig. 3 ont été croisées involontairement et sont respectivement reliées aux bornes 1B3 et 1B2 du premier bornier 1B et donc aux bornes des diodes antiparallèles DV1 et DR2. Comparativement également à la Fig. 1, les premières (ou secondes) extrémités 1E1 et 1E4 des fils F1 et F4 dans la Fig. 4 ont été croisées pour être involontairement reliées aux bornes 1B4 et 1B1 du premier bornier 1B, respectivement. Dans ces deux configurations de croisement de fils, lorsque le premier module 1M est connecté au premier bornier 1B, les interrupteurs I1 et I2 demeurant ouverts, la diode DR1 s'allume pour signaler la continuité électrique dans les deux paires, et plus généralement dans le bus BU, et la diode DR2 s'allume également. En effet le courant circule, selon la Fig. 3, à travers le fil F1, la résistance RT1, le fil F2, la diode DR2, le fil F3, la résistance RT2 et le fil F4 ; selon la Fig. 4, le courant circule à travers le fil F4, la résistance RT2, le fil F3, la diode DR2, le fil F2, la résistance RT1 et le fil F1.

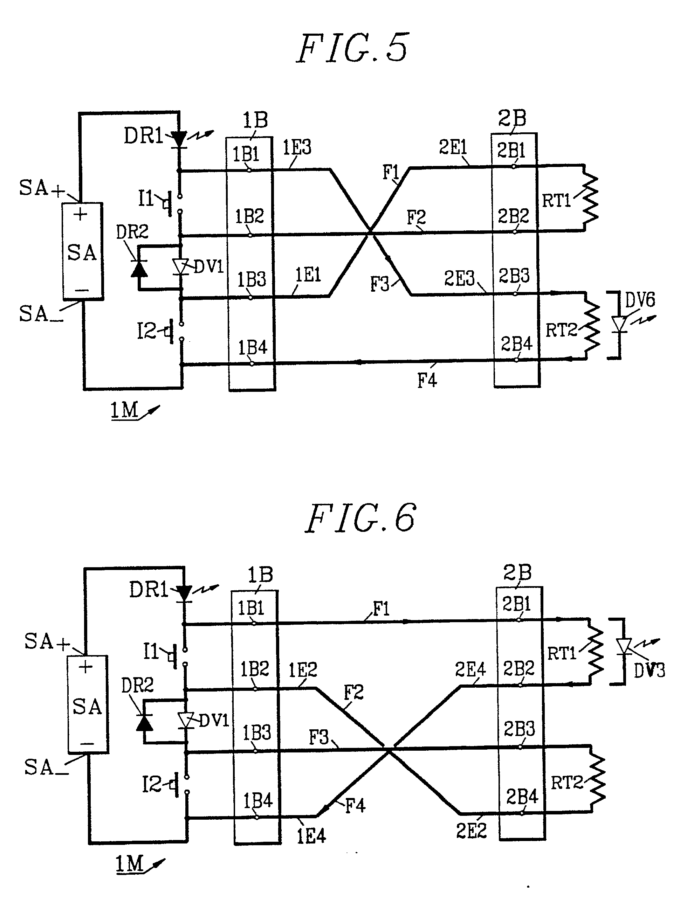

Si lors de l'enfichage du module 1M dans le bornier 1B1, seule la première diode DR1 s'allume, ceci signifie que le câblage du bus BU est suivant l'une des configurations montrées aux Figs. 5 et 6.

Selon la Fig. 5, les premières (ou secondes) extrémités 1E1 et 1E3 des fils F1 et F3 des paires P1 et P2 ont été croisées involontairement pour être reliées aux bornes 1B3 et 1B1 du bornier 1B, respectivement. Dans ces conditions, le courant circule à partir de la borne SA+ à travers la diode DR1, le fil F3, la résistance RT2 et le fil F4. La boucle formée par le fil F1, la résistance RT1, le fil F2 et les diodes antiparallèles DV1 et DR2 est complètement déconnectée de la source d'alimentation SA.

Selon la Fig. 6, les secondes (ou premières) extrémités 2E2 et 2E4 des fils F2 et F4 dans les paires P1 et P2 ont été involontairement croisées pour être reliées aux bornes 2B4 et 2B2 du second bornier 2B, respectivement. Dans ces conditions, le courant circule à partir de la borne d'alimentation SA+, à travers la diode DR1, le fil F1, la résistance RT1 et le fil F4. Le fil F2, la résistance RT2, le fil F3 et les diodes antiparallèles DV1 et DR2 sont reliés en une boucle complètement déconnectée de la source d'alimentation SA.

Afin de mieux distinguer les signalements de discontinuité électrique et de croisement de fils entre paires, les diodes DV1 et DR2 peuvent être de couleurs différentes, par exemple verte et bleue.

La distinction entre les erreurs de câblage des fils conducteurs selon les Figs. 3 et 4 d'une part, et selon les Figs. 5 et 6 d'autre part s'effectue en remplaçant les résistances terminales RT1 et RT2 par des paires de diodes électroluminescentes antiparallèles DV3-DR3 et DV6-DR6. Dans chacune de ces paires, les diodes ont de préférence des couleurs différentes. La diode DV3 est directement polarisée de la borne 2B1 vers la borne 2B2 du second bornier 2B et est connectée an antiparallèle à la diode DR3. La diode DV6 est directement polarisée de la borne 2B3 vers la borne 2B4 et est connectée en antiparallèle à la diode DR6. Les anomalies de câblage selon les Figs. 3 et 4 correspondant à la diode DR2 allumée se distinguent entre elles respectivement par les diodes DV3 et DV6 seulement allumées et les diodes DR6 et DR3 seulement allumées du côté du second bornier 2B. La distinction entre les anomalies de câblage selon les Figs. 5 et 6 correspondant à la diode DR2 éteinte se distinguent entre elles respectivement par la diode DV6 seulement allumée et la diode DV3 seulement allumée du côté du second bornier B2.

Selon d'autres variantes pour le test des croisements de fils entre paires, les diodes DV3 et DV6 peuvent être en série ou parallèle avec les résistances respectives RT1 et RT2, ou peuvent être incluses dans un second module 2M décrit ci-après, dont l'unique interrupteur I3 est à l'état ouvert.

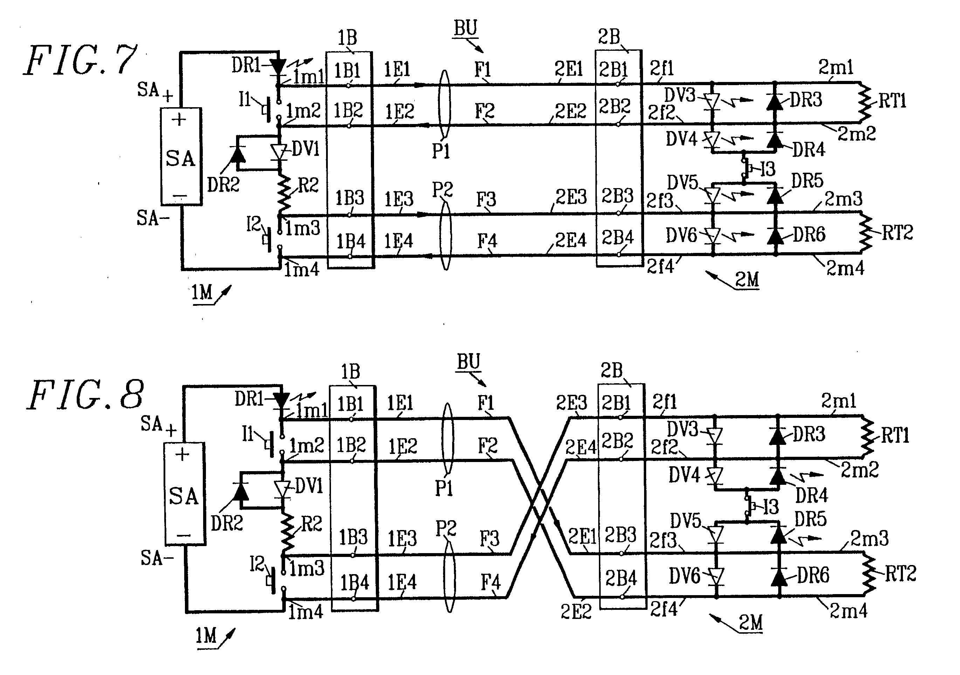

En référence maintenant à la Fig. 7, on y retrouve la configuration normale du bus BU selon la Fig. 1, et le dispositif de test comprend en addition un second module passif 2M qui est interconnecté entre le second bornier 2B et les résistances de terminaison RT1 et RT2.

Le module 2M offre deux séries de quatre bornes. Une première série de bornes 2f1, 2f2, 2f3 et 2f4 du module 2M sont connectables par enfichage aux bornes 2B1 à 2B4 du second bornier 2B. Dans une seconde série de quatre bornes de module 2M, deux bornes 2m1 et 2m2 sont reliées par la résistance de terminaison RT1, et les deux autres bornes 2m3 et 2m4 sont reliées par la résistance de terminaison RT2. Les premières bornes 2f1 à 2f4 sont reliées électriquement deux-à-deux aux secondes bornes 2m1 à 2m4 dans le bornier 2B, respectivement.

Le module 2M comprend un premier jeu de quatre diodes électroluminescentes DV3, DV4, DV5 et DV6 et un interrupteur I3. La diode DV3 a une anode reliée aux bornes 2f1 et 2m1 et une cathode reliée aux bornes 2f2 et 2m2. La diode DV4, l'interrupteur I3 et la diode DV5 sont reliés en série entre les bornes reliées 2f2 et 2m2 et les bornes reliées 2f3 et 2m3. L'anode de la diode DV4 est reliée aux bornes 2f2 et 2m2 et la cathode de cette diode est reliée à une borne de l'interrupteur I3. L'anode de la diode DV5 est reliée à l'autre borne de l'interrupteur I3, et la cathode de cette diode est reliée aux bornes 2f3 et 2m3. La dernière diode DV6 a une anode reliée aux bornes 2f3 et 2m3 et une cathode reliée aux bornes reliées 2f4 et 2m4. Les diodes DV4 et DV5 peuvent être remplacées par une seule diode LED.

Le module 2M comprend également quatre autres diodes électroluminescentes DR3 à DR6 qui sont respectivement connectées en antiparallèle avec les diodes DV3 à DV6.

Après avoir constaté que les diodes DR1 et DV1 étaient allumées et que la diode DR2 était éteinte lors de l'enfichage du premier module 1M dans le bornier 1B, selon la Fig. 1 ou 7, les tests sont poursuivis en interconnectant le module 2M selon la configuration montrée à la Fig. 7. Dans cette configuration où le bus BU est normal, on constate que les autre diodes DV3 à DV6 dans le second module 2M sont allumées lorsque l'interrupteur I3 est fermé et que le bus ne présente aucune anomalie. De préférence les diodes DV3 à DV6 sont associées à une même couleur ici verte qui est différente de la couleur des diodes DR3 à DR6, ici rouge. Le module 2M s'illumine donc fortement en vert. En effet, les diodes DV3 à DV6 dans le module 2M sont polarisées directement, et en particulier les diodes DV3 et DV6 "courtcircuitent" les résistances RT1 et RT2 et les diodes DV4 et DV5 "courtcircuitent" les diodes DV1 et DR2 dans le premier module.

Afin de mieux distinguer l'illumination entre le module 2M et le module 1M, bien qu'ils soient généralement éloignés en pratique, une résistance R2 est de préférence connectée en série avec la combinaison des diodes anti-parallèles DV1 et DR2 dans le premier module 1M, entre les bornes 1m2 et 1m3, comme montré à la Fig. 7, de manière à diminuer le courant traversant les fils F2 et F3 par rapport à celui traversant la diode DV4, l'interrupteur I3 et la diode DV5, d'une manière analogue au courant très faible traversant les résistances de terminaison RT1 et RT2 comparativement au courant plus élevé traversant les diodes DV3 et DV6. Le rouge de la diode DR1 est prépondérant, tandis que le second module 2M est en vert.

Si, lorsque l'interrupteur I3 est fermé, la luminescence des diodes DR4 et DR5 est prépondérante dans le second module 2M, ceci indique que les paires de fils conducteurs P1 et P2 ont été croisées, comme montré à la Fig. 8. Dans cette figure, on a supposé que les secondes (ou premières) extrémités 2E1 et 2E2 des fils F1 et F2 de la première paire P1 sont involontairement reliées aux bornes 2f3 et 2f4 du second module 2M à travers les bornes de bornier 2B3 et 2B4, et les secondes extrémités 2E3 et 2E4 des fils F3 et F4 de la seconde paire P2 sont reliées involontairement aux bornes 2f1 et 2f2 du second module 2M à travers les bornes de bornier 2B1 et 2B2. Le courant circule à partir du fil F1 vers le fil F4 principalement à travers la combinaison série de la diode DR5, l'interrupteur I3 et la diode DR4, puisque la boucle formée par la résistance de terminaison RT2, le fil F2, la diode DV1, la résistance R2, le fil F3 et la résistance de terminaison RT1 présente · une résistance plus élevée. Le très faible courant circulant à travers les diodes DV6, DV1 et DV3 n'active que très faiblement celles-ci comparativement à l'illumination très forte par les diodes DR4 et DR5. Dans ces conditions, le second module 2M s'illumine nettement en rouge, comme le premier module 1M.

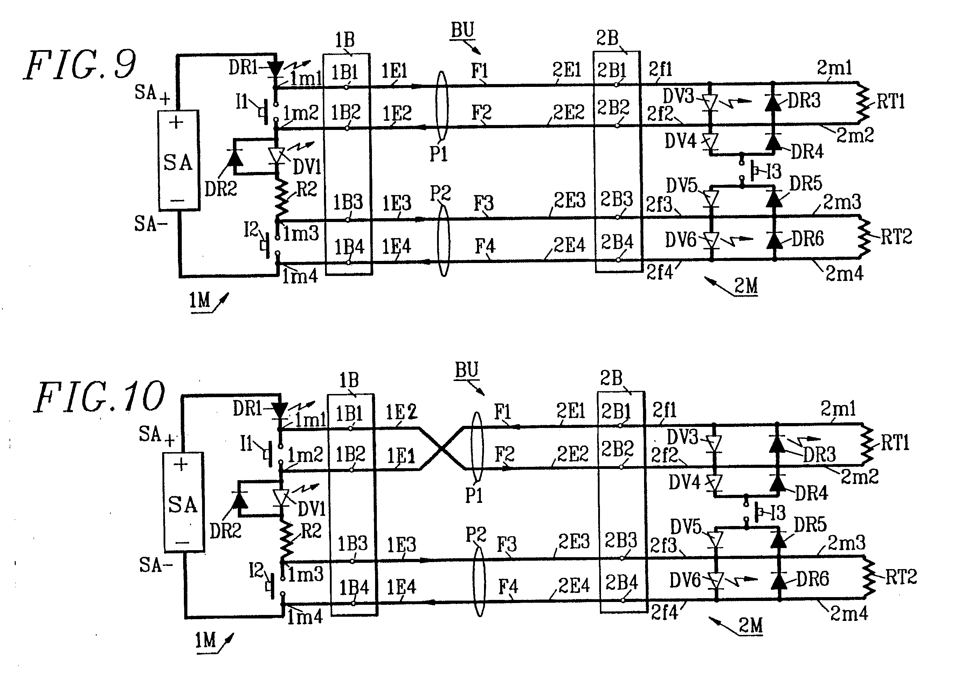

En référence à la Fig. 9, qui est analogue à la Fig. 7, l'interrupteur I3 dans le module 2M est cependant à l'état ouvert. Le module 2M est également illuminé en vert, puisque la majorité du courant d'alimentation traverse les diodes polarisées directement DV3 et DV6. Les couples de diode DV4 et DR4, et DV5 et DR5 sont déconnectées par l'interrupteur ouvert I3.

Lorsque l'une seulement des diodes DV3 et DV6 est éteinte et que la diode montée en antiparallèle DR3, DR6 est dans l'état inverse à celui de la diode respective DV3, DV6, ceci signifie que le bus présente un croisement des fils dans l'une des paires P1 et P2. Ce cas est illustré dans la Fig. 10, où l'on a supposé que les premières (ou secondes) extrémités 1E1 et 1E2 des fils F1 et F2 de la première (ou seconde) paire P1 sont involontairement croisées et respectivement reliées aux bornes 1B2 et 1B1 du premier bornier 1B. Dans ce cas, le courant d'alimentation circule à partir de la borne 1m1, dans le fil F2, en majorité à travers la diode DR3 qui s'illumine en rouge, à travers le fil F1, puis à travers la diode DV1 et la résistance R2 dans le premier module 1M, dans le fil F3, en majorité à travers la diode DV6 qui s'illumine en vert, et finalement dans le quatrième fil F4.

D'une manière analogue, si les fils F3 et F4 sont involontairement croisés dans la seconde paire P2, la diode DV3 demeure allumée, tandis que la diode DV6 est éteinte et la diode associée DR6 s'allume, comparativement à la Fig. 9.

Il est à noter que, lorsque le second module 2M est utilisé avec l'interrupteur I3 à l'état ouvert pour détecter des croisements entre les fils des paires, et lorsque les diodes DV3 et DV6 sont allumées, la diode DR2 est allumée selon la Fig. 3 et la diode DV1 est allumée selon la Fig. 9 dans le module 1M. Les autres configurations d'anomalies entre les Figs. 4, 5, 6 et 9, 10 se distinguent encore plus nettement au niveau du second module 2M.

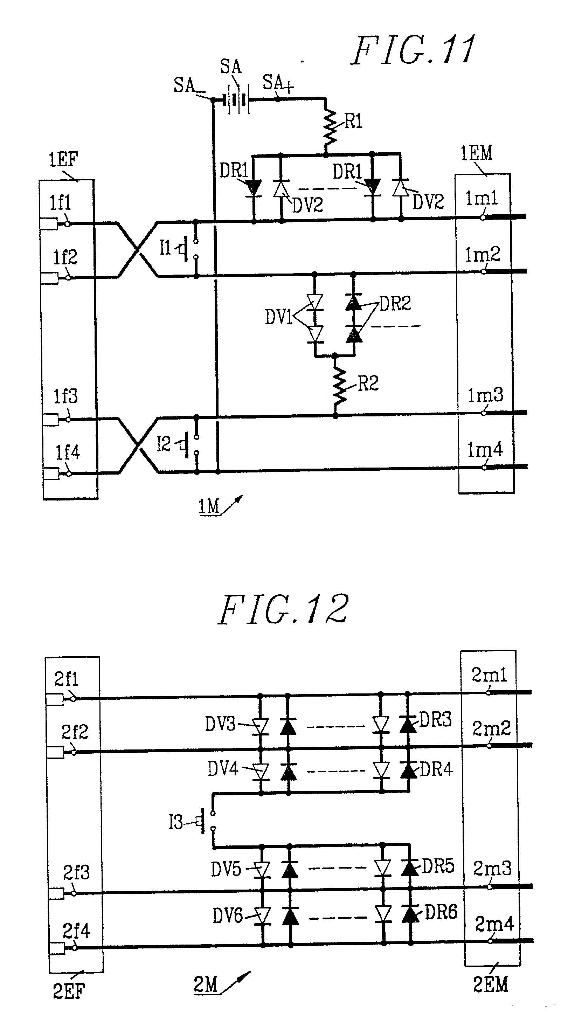

Les modules 1M et 2M décrits ci-dessus offrent des configurations minimales pour tester convenablement un bus BU. Cependant de préférence, les modules 1M et 2M présentent des éléments électroniques agencés comme dans les Figs. 11 et 12.

Selon la Fig. 11, un premier module 1M selon l'invention comprend, entre les bornes d'alimentation SA+ et SA-, les éléments en série suivants à partir de la borne SA+ : une résistance R1, au moins deux jeux ayant chacun deux diodes antiparallèles DR1 et DV2, qui sont de couleurs différentes et respectivement polarisées directement et en inverse de la bornes SA+ vers la borne SA-, un interrupteur I1, au moins un jeu de deux diodes en série DV1 connectées en antiparallèle avec au moins un jeu de deux diodes en série DR2, les diodes DV1 et DR2 étant de couleurs différentes et respectivement polarisées directement et en inverse à partir de la borne SA+ vers la borne SA-, une résistance R2, et un interrupteur I2. Comme dans la Fig. 1, les bornes 1m1 et 1m2 et les bornes 1m3 et 1m4 d'un premier bornier 1EM du module 1M constituent respectivement les bornes des interrupteurs I1 et I2. Dans le cas de la configuration normale du bus BU à tester par le module 1M, selon la combinaison des Figs. 1 et 11, chacune des deux diodes parallèles DR1 est parcourue par un courant qui est la moitié de celui qui parcourt les diodes séries DV1. Dans ce cas le module 1M s'allume en "vert-jaune" ce qui permet de distinguer plus nettement cette configuration par rapport à des illuminations en vert ou en rouge du module 1M.

Le module 1M présente également un second bornier 1EF ayant quatre bornes 1f1, 1f2, 1f3 et 1f4 respectivement reliées électriquement aux bornes 1m2, 1m1, 1m4 et 1m3, suite à un croisement de conducteurs par paires dans le module 1M.

Dans la Fig. 12, le second module 2M présente deux borniers 2EF et 2EM, et un interrupteur I3, comme dans la Fig. 7 ou 9. Toutefois, le module 2M comprend à la place de chaque jeu de diodes antiparallèles DV3-DR3, DV4-DR4, DV5-DR5 et DV6-DR6, deux ou plusieurs tels jeux de diodes antiparallèles. Le nombre d'ensemble de jeux de diodes antiparallèles DR1-DV2, et DV1-DR2 dans le premier module 1M, et le nombre de jeux de diodes antiparallèles DV3-DR3 à DV6-DR6 dans le second module 2M dépendent des caractéristiques du bus, et plus particulièrement des impédances caractéristiques des paires P1 et P2 et des impédances terminales RT1 et RT2. Ces nombres de diode sont choisis également en fonction de l'intensité des illuminations recherchée dans les modules 1M et 2M.

Par exemple, dans le module 1M, le premier bornier 1EM présente des bornes 1m1 à 1m4 du genre prises mâles, et l'autre bornier IEF présente des bornes 1f1 à 1f4 du genre prises femelles, en supposant que les borniers 18 et 28 du bus soient respectivement du type à prises femelles et à prises mâles. Dans le second module 2M, les borniers 2EF et 2EM comprennent de préférence des prises femelles 2f1 à 2f4 et des prises mâles 2m1 à 2m4 respectivement. En pratique, les modules de test 1M et 2M sont sous la forme de petits boîtiers présentant sur des faces opposées les borniers, et contenant un circuit imprimé supportant les diodes, résistances et interrupteurs et des conducteurs imprimés de liaison. La source SA peut être une batterie de piles. Les borniers femelle et mâle des modules et du bus présentent des moyens mécaniques de détrompage complémentaires pour signaler un retournement à 180° d'un bornier par rapport à l'autre.

Selon d'autres variantes, chacun des modules 1M et 2M comprend des moyens logiques de manière à signaler par trois voyants comportant des inscriptions correspondant à l'absence des anomalies, selon les Figs. 1, 7 et 9, respectivement, et par d'autres voyants respectifs les anomalies selon les Figs. 2 à 6, 8 et 10. En effet, chacune des diodes électroluminescentes est équivalente à un moyen détecteur local de courant, et les activations de ces moyens détecteurs de courant peuvent être combinées logiquement pour exciter les voyants. Un tel moyen détecteur de courant peut être un élément photoémetteur, tel que LED, qui est couplé à un élément photorécepteur, tel que photorésistance ou phototransistor, inclus dans un circuit optologique contenant lesdits ' voyants à inscription. Selon une autre variante, chaque moyen détecteur de courant est un circuit à transistor classique ou à relais inclus dans un circuit logique contenant lesdits voyants à inscription.

L'enfichage de l'un des borniers de l'un des modules 1M et 2M dans l'un des borniers de l'autre module permet de juger du bon état de la charge de piles, lorsque celles-ci constituent la source de tension SA, et de tester le bon état des moyens de signalisation, à savoir les diodes électroluminescentes dans les deux modules.

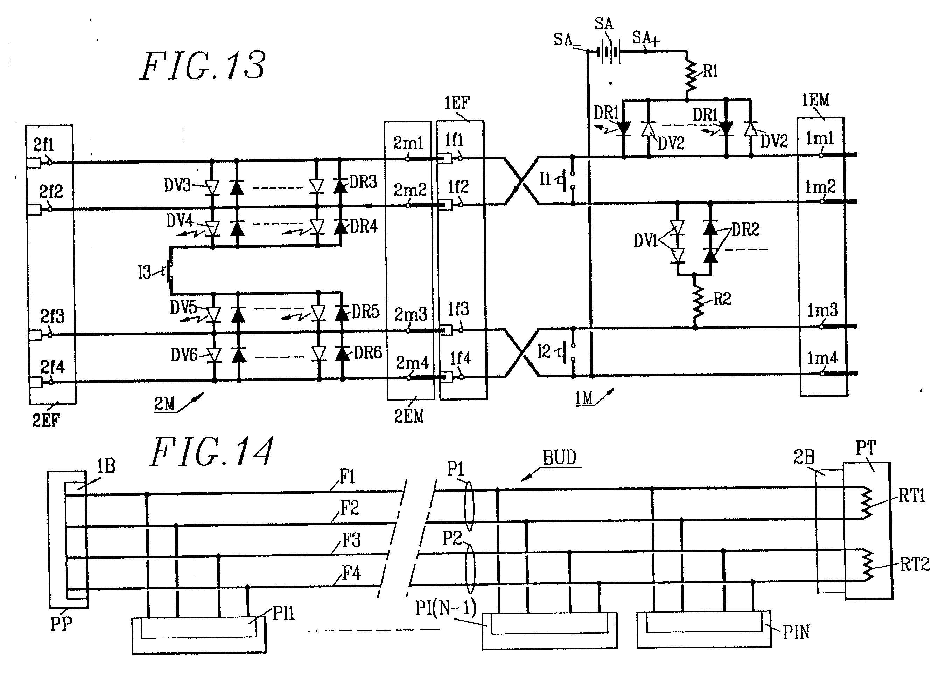

A titre d'exemple, en référence à la Fig. 13, le bornier 2EM du module 2M est enfiché dans le bornier 1EF du module 1M, de manière à connecter respectivement les bornes 2m1 à 2m4 aux bornes 1f1 à 1f4. Du fait que les conducteurs de liaison dans le module 1M sont croisés entre les interrupteurs I1 et I2 et le bornier IEF, on se retrouve dans une configuration analogue à celle du câblage anormal montrée à la Fig. 10, mais avec un croisement dans chacune des paires de conducteurs. Lorsque l'interrupteur I3 dans le module 2M est fermé, comme montré à la Fig. 13, le courant d'alimentation active la diode rouge DR1 dans le premier module, et traverse en majeure partie les diodes vertes DV4 et DV5 qui sont activées dans le second module 2M, puis finalement traversent les bornes 2m3 et 1f3. Le premier module est donc rouge et le second module est vert.

Lorsque l'interrupteur I3 est ouvert, le courant d'alimentation traverse la diode rouge DR1 dans le premier module, les diodes rouges DR3 dans le second module, les diodes DV1 dans le premier module, et finalement les diodes rouges DR6 dans le second module. Le premier module 1M est alors illuminé en jaune, et le second module 2M est illuminé en rouge. Pour tester le bon fonctionnement des autres diodes DV3, DR4, DR5 et DV6 dans le second module, il suffit de retourner de 180° le second module par rapport au premier module dans la Fig. 1, de manière à connecter respectivement les bornes 1f1 à 1f4 du premier module aux bornes 2m4 à 2m1 du second module, et à ouvrir l'interrupteur I3.

Pour tester les diodes DV2 et DR2 dans le premier module 1M, il suffit d'inverser la polarisation des bornes d'alimentation en retournant les piles d'alimentation. Il est à noter que les diodes DV2 ne sont pas véritablement utiles pour le test du bus BU mais qu'elles sont incluses dans le module 1M, d'une part parce que celui-ci fait appel à des jeux de diodes antiparallèles de manière à limiter le coût de fabrication des modules 1M et 2M, d'autre part parce qu'elles peuvent remplacer les diodes DR1 lorsque les bornes d'alimentation SA + et SA- sont inversées.

L'autre test des modules 1M et 2M selon des connexions analogues à celles montrées à la Fig. 13, intervient bien entendu avant de procéder aux tests de continuité électrique et de oroisement entre deux fils des deux paires P1 et P2 au moyen du module 1M, en référence à la Fig. 1, suivi des tests de croisement des paires P1 et P2 et de permutation des fils dans chacune des paires en référence aux Figs. 7 et 9.

Un dispositif de test conforme à l'invention n'est pas limité à tester un bus simple à quatre conducteurs auquel il a été fait référence ci-dessus. En particulier, le dispositif de test sert à déceler des anomalies dans un bus distribué BUD entre une prise principale PP et une prise terminale PT, vers N prises intermédiaires de terminaux PI1 à PIN, comme montré à la Fig. 14. Le bus peut être l'un des bus d'un réseau local du type RNIS dans lequel une première paire P1 de fils F1 et F2 est assignée à une direction de transmission des signaux et dans lequel une seconde paire P2 de fils F3 et F4 est assignée à l'autre sens de transmission. Par exemple, les fils F1 et F3 sont de polarité positive et les fils F2 et F4 sont de polarité négative. La prise PP est constituée par un bornier 1B et la prise PT est constituée par un bornier 2B auquel sont reliées deux impédances terminales RT1 et RT2 affectées aux deux paires. Les quatre types de test qui ont été décrits ci-dessus pour le bus BU sont également réalisés pour tester le bus distribué BUD. Toutefois, lorsqu'une anomalie est signalée par cette première série de tests entre les prises PP et PT, d'autres tests sont effectués entre la prise PP et les prises PI1 à PIN respectivement, de manière à localiser l'anomalie le long du bus distribué BUD.

## Revendications

1- Dispositif pour tester un bus (BU), ledit bus comprenant
des premier, second, troisième et quatrième fils conducteurs parallèles (F1 à F4),
un premier bornier (1B) ayant des première, seconde, troisième et quatrième bornes (1B1 à 1B4) respectivement reliées normalement à des premières extrémités (1E1 à 1E4) des premier, second, troisième et quatrième fils conducteurs (F1 à F4),
un second bornier (2B) ayant des première, seconde, troisième et quatrième bornes (2B1 à 2B4) respectivement reliées normalement à des secondes extrémités (2E1 à 2E4) des premier, second, troisième et quatrième fils conducteurs (F1 à F4), et
des première et seconde impédances terminales (RT1, RT2) connectables respectivement aux première et seconde bornes (2B1, 2B2) du second bornier et aux troisième et quatrième bornes (2B3, 2B4) du second bornier,
caractérisé en ce que le dispositif de test comprend
une source de tension continue (SA),
un premier interrupteur (I1) connectable aux première et seconde bornes (1B1, 1B2) du premier bornier (1B),
un second interrupteur (I2) relié en série avec la source de tension et le premier interrupteur et connectable aux troisième et quatrième bornes (1B3 et 1B4) du premier bornier (1B),
un premier moyen détecteur de courant (DR1) polarisé directement par la source de tension et interconnecté en série entre la source de tension (SA) et lesdits interrupteurs (I1, I2), et
un second moyen détecteur de courant (DV1) polarisé directement par la source de tension (SA) et interconnecté en série entre les premier et second interrupteurs (I1, I2).

2 - Dispositif conforme à la revendication 1, caractérisé en ce que le premier moyen détecteur de courant comprend deux éléments photoémetteurs connectés en parallèle (DR1), et en ce que le second moyen détecteur de courant comprend deux éléments photoémetteurs connectés en série (DV1).

3 - Dispositif conforme à la revendication 1 ou 2, caractérisé en ce qu'il comprend une résistance (R2) connectée en série avec le second moyen détecteur de courant (DV1) entre les seconde et troisième bornes (1B2, 1B3) du premier bornier (1B).

4 - Dispositif conforme à l'une quelconque des revendications 1 à 3, caractérisé en ce qu'il comprend un troisième moyen détecteur de courant (DR2) relié en antiparallèle avec le second détecteur de courant (DV1).

5 - Dispositif conforme à l'une quelconque des revendications 1 à 4, caractérisé en ce qu'il comprend un quatrième moyen détecteur de courant (DV2) relié en antiparallèle avec le premier moyen détecteur de courant (DR1).

6 - Dispositif conforme à l'une quelconque des revendications 1 à 5, caractérisé en ce que la source d'alimentation de tension (SA), les interrupteurs (I1, I2) et les moyens détecteurs de courant (DR1, DV1 ; DR2, DV2) sont logés dans un premier module (1M) enfichable dans le premier bornier (1B).

7 - Dispositif de test conforme à l'une quelconque des revendications 1 à 6, caractérisé en ce qu'il comprend des cinquième et sixième moyens détecteurs de courant (DV4, DR4 et/ou DV5 ; DR5) connectables en antiparallèle entre les seconde et troisième bornes (2B2, 2B3) du second bornier (2B), et un troisième interrupteur (I3) connecté en série avec les cinquième et sixième détecteurs de courant (DV4, DR4, et/ou DV5, DR5) entre les seconde et troisième bornes (2B2 et 2B3) du second bornier (2B).

8 - Dispositif conforme à l'une quelconque des revendications 1 à 7, caractérisé en ce qu'il comprend des septième et huitième moyens détecteurs de courant (DV3, DR3) connectables en antiparallèle entre les première et seconde bornes (2B1, 2B2) du second bornier (2B), et des neuvième et dixième moyens détecteurs de courant (DV6, DR6) connectables en antiparallèle entre les troisième et quatrième bornes (2B3, 2B4) du second bornier (2B).

9 - Dispositif conforme à la revendication 7 ou 8, caractérisé en ce que les moyens détecteurs de courant (DV4, DV5 ; DR4, DR5 ; DV3, DR3 ; DV6, DR6) connectables à des bornes du second bornier de bus (2B) sont inclus dans un second module enfichable dans le second bornier (2B) et interconnectable entre le second bornier (2B) et les deux impédances de terminaison (RT1, RT2).

10 - Dispositif conforme aux revendications 6 et 9, caractérisé en ce que les bornes des premier et second interrupteurs (I1, I2) sont reliées à des première, seconde, troisième et quatrième bornes (1m1 à 1m4) d'un bornier (1EM) du premier module (1M) connectables respectivement aux première, seconde, troisième et quatrième bornes (1B1 à 1B4) du premier bornier de bus (1B), et sont reliées à des seconde, première, quatrième et troisième bornes (1f2, 1f1, 1f4, 1f3) d'un autre bornier (1EF) du premier module connectables respectivement à des seconde, première, quatrième et troisième bornes (2m2, 2m1, 2m4, 2m3) de l'un (2EF) des deux borniers (2EF, 2EM) du second module (2M), et en ce que les première, seconde, troisième et quatrième bornes (2m1, 2f1 à 2m4, 2f4) des borniers du second module (2M) constituent des bornes des moyens détecteurs de courant contenus dans le second module et sont connectables aux première, seconde, troisième et quatrième bornes (2B1 à 2B4) du second bornier de bus (2B).

11 - Dispositif conforme à l'une quelconque des revendications 1 à 10, caractérisé en ce que chacun desdits moyens détecteurs de courant (DV1 à DV6, DR1 à DR6) comprend au moins un élément photoémetteur.

12 - Dispositif conforme aux revendications 4 et 11, caractérisé en ce que les éléments photoémetteurs sont des diodes électroluminescentes, et les diodes (DR1, DR2) dans les premier et troisième moyens détecteurs de courant sont associées à une couleur qui est différente de celle de la diode dans le second moyen détecteur de courant (DV1).

13 - Dispositif conforme aux revendications 7 et 8 et à la revendication 11 ou 12, caractérisé en ce que les éléments photoémetteurs sont des diodes électroluminescentes, et les diodes dans les cinquième, septième et neuvième détecteurs de courant (DV4, DV5, DV3, DV6) ont une couleur qui est différente de celle des diodes dans les sixième, huitième et dixième détecteurs de courant (DR4, DR5, DR3, DR6).

# *FIG.1*

# *FIG.2*

# FIG.3

# FIG.4

# FIG.5

# FIG.6

*FIG.7*

*FIG.8*

EP 0 425 374 A1

*FIG. 9*

*FIG. 10*

*FIG.11*

*FIG.12*

*FIG.13*

*FIG.14*

Office européen
des brevets

RAPPORT DE RECHERCHE
EUROPEENNE

Numéro de la demande

EP 90 40 2998

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 074 187  (MILLER et al.)<br>* Abrégé; colonne 3, ligne 45 - colonne 5, ligne 27; figures 1,2 *<br>— — — | 1-6,8,9, 11-13 | G 01<br>R 31/02 |
| A | GB-A-2 203 560  (HEIDELBERGER DRUCKMASCHINEN AG)<br>* Abrégé; page 14, alinéa 2 - page 15, alinéa 2; figure 4 *<br>— — — | 1,6 | |
| A | ELECTRICAL DESIGN NEWS, vol. 31, no. 11, mai 1986, page 299, Boston, MA, US; M.D. BRAUNSTEIN: "Simple circuit tests twisted-pair cables"<br>* Document entier *<br>— — — | 1,2,6,9,11 | |
| A | ELECTRONICS, vol. 47, no. 20, 3 octobre 1974, page 125; E.L. RAUB, Jr.: "Simple cable tester spots faults, identifies repairs"<br>* Document entier *<br>— — — — — | 1,6,7,8,9, 11,13 | |

| | | | DOMAINES TECHNIQUES RECHERCHES (Int. Cl.5) |
|---|---|---|---|
| | | | G 01 R |

Le présent rapport de recherche a été établi pour toutes les revendications

| Lieu de la recherche | Date d'achèvement de la recherche | Examinateur |
|---|---|---|
| La Haye | 01 février 91 | SINAPIUS G.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons

& : membre de la même famille, document correspondant